# FASCICULE DE BREVET EUROPEEN

(11) **EP 1 011 191 B1**
(45) Date de publication et mention de la délivrance du brevet: **07.01.2009**
(21) Numéro de dépôt: 99204014.7
(22) Date de dépôt: 29.11.1999
(51) Int. Cl.: H03D 7/16, H03H 11/08

(54) **Dispositif de filtrage pour éliminer une composante continue**
Filteranordnung zur Unterdrückung einer Gleichstromkomponente
Filter device for eliminating a DC component

(30) Priorité: 08.12.1998 FR 9815484
(43) Date de publication de la demande: 21.06.2000
(73) Titulaire: NXP B.V., 5656 AG Eindhoven (NL)
(72) Inventeur: Greer, Nigel, 75008 Paris (FR)
(74) Mandataire: Zapalowicz, Francis

(56) Documents cités:
- US-A- 5 548 244
- GWILYM LUFF: "A SINGLE-CHIP VHF AND UHF RECEIVER FOR RADIO PAGING" IEEE INTERNATIONAL SOLID STATE CIRCUITS CONFERENCE, vol. 34, 1 février 1991 (1991-02-01), pages 120-121, 300, XP000237821 ISSN: 0193-6530
- K. KRAUS: "CAUER FILTER MIT GYRATOREN TCA 580" NACHRICHTEN ELEKTRONIK., vol. 32, no. 12, décembre 1978 (1978-12), XP002113885 VERLAG DR. HUETHIG. HEIDELBERG., DE

## Description

La présente invention concerne un dispositif de filtrage destiné à éliminer une composante continue d'un signal électronique.

De tels dispositifs de filtrage sont couramment utilisés dans des appareils servant à la réception de signaux radioélectriques, tels des téléviseurs ou des radiotéléphones. Ces appareils comportent classiquement un circuit de réception, disposé à la suite d'un système d'antenne et de filtrage destiné à assurer la réception d'un signal radioélectrique et à délivrer sur une sortie un signal électronique représentatif dudit signal, circuit de réception comportant:
- un amplificateur relié à la sortie du système d'antenne et de filtrage et destiné à délivrer un signal électronique amplifié,
- un mélangeur muni d'une première entrée reliée à la sortie de l'amplificateur, d'une deuxième entrée destinée à recevoir un signal en provenance d'un oscillateur local, et d'une sortie, et
un démodulateur muni d'une entrée reliée à la sortie du mélangeur et d'une sortie destinée à délivrer un signal audio démodulé en fréquence.

La sortie du mélangeur et l'entrée du démodulateur sont le plus souvent doubles, respectivement destinées à délivrer et à recevoir des couples de signaux de même allure en quadrature de phase. Les éléments inclus dans le circuit de réception décrit ci-dessus opèrent généralement de fortes amplifications des signaux qu'ils traitent, du fait de la faible amplitude initiale du signal radioélectrique. Si le signal traité par un des éléments précités possède une composante continue, celle-ci se trouvera également amplifiée, provoquant ainsi un important décalage de la composante alternative du signal traité, composante alternative qui contient l'information utile véhiculée par le signal. Un tel décalage peut provoquer une saturation d'étages de sortie destinés à amplifier le signal traité, ou encore d'étages d'entrée d'éléments destinés à recevoir le signal amplifié, et donc provoquer un écrêtage dudit signal entraînant une altération de l'information qu'il représente, ce qui n'est pas acceptable.

Ainsi, dans les appareils destinés à la réception de signaux radioélectriques décrits plus haut, un dispositif de filtrage est souvent inséré entre le mélangeur et le démodulateur, dans le but d'éliminer la composante continue du signal de sortie du mélangeur. Les dispositifs de filtrage employés à cet effet sont souvent des filtres passe-haut, constitués d'une résistance et d'une capacité, filtres ayant une fréquence de seuil au-delà de laquelle ils sont passants choisie inférieure à la fréquence de la composante alternative du signal de sortie du mélangeur, qui est fixe et appelée fréquence intermédiaire.

L'article intitulé « A Single-Chip VHF and UHF Receiver for Radio Paging » par Gwilym Luff et al., IEEE International Solid State Circuits Conference, vol. 34, 1 février 1991, pages 120-121, et 300, décrit un récepteur dans lequel la composante continue provenant du mélangeur est éliminée par un filtre passe-haut. Le filtre principal du canal est une implémentation d'un filtre elliptique du septième ordre comprenant des gyrateurs et des capacités.

L'utilisation d'un filtre passe-haut dans le but d'éliminer la composante continue présente d'importants inconvénients. La valeur de la fréquence intermédiaire étant de l'ordre de la dizaine ou de la centaine de KiloHertz, on choisit classiquement, pour la fréquence de seuil, une valeur de l'ordre du KiloHertz pour la fréquence de coupure. Cette valeur, étant relativement faible, conduit à utiliser pour réaliser le filtre passe-haut une capacité ayant une valeur relativement élevée, de l'ordre du NanoFarad. Or, dans l'état actuel de la technologie des circuits intégrés, une telle capacité n'est réalisable que sous forme discrète, ce qui implique que l'usage d'un filtre passe-haut décrit ci-dessus est un obstacle à l'intégration complète du circuit de réception, qui est pourtant souhaitable dans le but de réduire l'encombrement et la consommation dudit circuit. Par ailleurs, un filtre passe-haut comportant une forte capacité présente une constante de temps élevée et introduit donc au sein du circuit de réception une inertie temporelle importante. Dans des radiotéléphones conformes aux standards GSM ou TDMA, le circuit de réception n'est activé que pendant de brèves périodes au cours-desquelles ledit circuit doit assurer la réception d'un paquet d'informations, après quoi il est à nouveau désactivé. Or, chaque activation du circuit de réception est suivie d'une phase d'initialisation, après laquelle la réception est possible. L'inertie temporelle introduite par la forte capacité incluse dans le filtre passe-haut risque d'augmenter la durée de la phase d'initialisation au détriment de l'intervalle de temps alloué au circuit pour opérer la réception du paquet d'information, ce qui risque de nuire au bon fonctionnement du circuit de réception. Enfin, la démodulation en fréquence du signal de sortie du mélangeur ne doit pas être perturbée par une dissymétrie dudit signal par rapport à la fréquence intermédiaire. Le circuit de réception doit donc présenter, dans la mesure du possible, une caractéristique de transfert symétrique autour de la fréquence intermédiaire. Or, la caractéristique de transfert d'un filtre passe-haut est symétrique autour de la fréquence nulle, et provoque ainsi une importante dissymétrie de la caractéristique de transfert du circuit de réception par rapport à la fréquence intermédiaire, ce qui peut également être néfaste au bon fonctionnement dudit circuit.

La présente invention a pour but de remédier dans une large mesure à ces inconvénients en proposant un dispositif de filtrage intégrable, ayant une inertie temporelle plus faible que celle des dispositifs de filtrage connus, et préservant la symétrie par rapport à la fréquence intermédiaire de la caractéristique de transfert du circuit de réception.

En effet, la revendication 1 définit un dispositif de filtrage selon l'invention.

Dans un tel dispositif de filtrage, on peut utiliser des capacités de faibles valeurs, aisément intégrables, en choisissant une caractéristique de transfert présentant au moins un zéro à une fréquence relativement élevée. Des gyrateurs opèrent alors un décalage de la caractéristique de transfert du dispositif de filtrage. Par ailleurs, comme on le verra par la suite, cette caractéristique de transfert retrouve une allure correspondant à un filtre passe-bande au-delà de la perturbation provoquée par le zéro du filtre. La symétrie de la caractéristique de transfert du dispositif de filtrage conforme à l'invention est donc préservée dans une large mesure.

La revendication 3 définit un mode de réalisation ayant une configuration de gyrateurs qui permet d'obtenir aisément le décalage du zéro de la caractéristique de transfert du dispositif de filtrage, afin que ce zéro corresponde à la fréquence nulle.

La revendication 4 définit un mode de réalisation dans lequel l'égalité des valeurs nominales des capacités et l'identité des gyrateurs permet de réduire l'influence des imperfections dues au procédé de réalisation du dispositif de filtrage, lesdites imperfections ayant ainsi théoriquement les mêmes effets sur tous les gyrateurs et toutes les capacités. Le choix de l'égalité des valeurs nominales des éléments capacitifs Ci permet ainsi d'obtenir une homogénéité de la dynamique du signal transitant au travers du dispositif de filtrage. Enfin, un tel choix permet de simplifier et d'optimiser la conception et la disposition surfacique du circuit intégré incluant le dispositif de filtrage, et donc d'en réduire la taille et le coût.

Ainsi qu'exposé plus haut, la mise en oeuvre d'un dispositif de filtrage conforme à l'invention est particulièrement avantageuse au sein d'un circuit de réception de signaux radioélectriques. L'invention concerne donc également un appareil de radiotéléphonie selon la revendication 5.

L'invention sera mieux comprise à l'aide de la description suivante, faite à titre d'exemple non-limitatif et en regard des dessins annexés, dans lesquels:
- la figure 1 est un schéma fonctionnel décrivant partiellement un appareil de radiotéléphonie incluant un dispositif de filtrage conforme à l'invention,
- la figure 2 est un schéma électrique décrivant un dispositif de filtrage conforme à l'invention,
- la figure 3 est un schéma électrique décrivant une partie d'un dispositif de filtrage conforme à un mode de réalisation particulier de l'invention,
- la figure 4 est une courbe représentant la caractéristique de transfert d'un filtre elliptique inclus dans un dispositif de filtrage conforme à l'invention,
- la figure 5 est une courbe représentant la caractéristique de transfert d'un dispositif de filtrage conforme à l'invention.

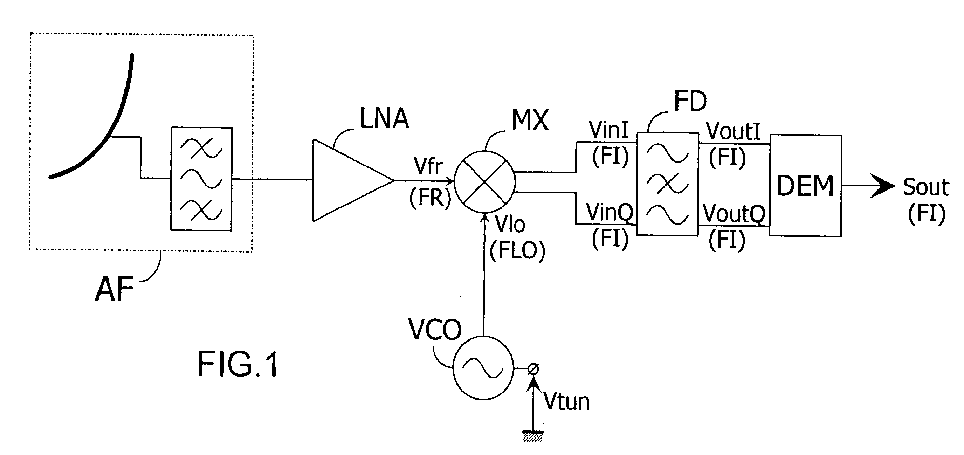

La figure 1 représente schématiquement un radiotéléphone. Cet appareil comporte un circuit de réception disposé à la suite d'un système d'antenne et de filtrage AF destiné à assurer la réception d'un signal radioélectrique et à délivrer sur une sortie un signal électronique représentatif dudit signal. Le circuit de réception comporte:
- un amplificateur LNA relié à la sortie du système d'antenne et de filtrage AF et destiné à délivrer sur une sortie un signal électronique amplifié Vfr,
- un mélangeur MX muni d'une première entrée reliée à la sortie de l'amplificateur LNA, d'une deuxième entrée destinée à recevoir un signal Vlo en provenance d'un oscillateur local VCO, et d'une sortie, et
- un démodulateur DEM muni d'une entrée reliée à la sortie du mélangeur MX et d'une sortie destinée à délivrer un signal audio démodulé Sout.

La sortie du mélangeur MX et l'entrée du démodulateur DEM sont doubles, respectivement destinées à délivrer et à recevoir des couples de signaux de même allure en quadrature de phase (VinI, VinQ) et (VoutI, VoutQ) ayant une fréquence FI usuellement appelée fréquence intermédiaire. Les éléments inclus dans le circuit de réception décrit ci-dessus opèrent de fortes amplifications des signaux qu'ils traitent, du fait de la faible amplitude initiale du signal radioélectrique. Dans le but de réduire les risques de saturation ou d'écrêtage du signal transitant au travers du circuit de réception, qui provoqueraient une altération de l'information véhiculée par ledit signal, un dispositif de filtrage FD est inséré entre le mélangeur MX et le démodulateur DEM, pour éliminer la composante continue du signal de sortie (VinI, VinQ) du mélangeur MX.

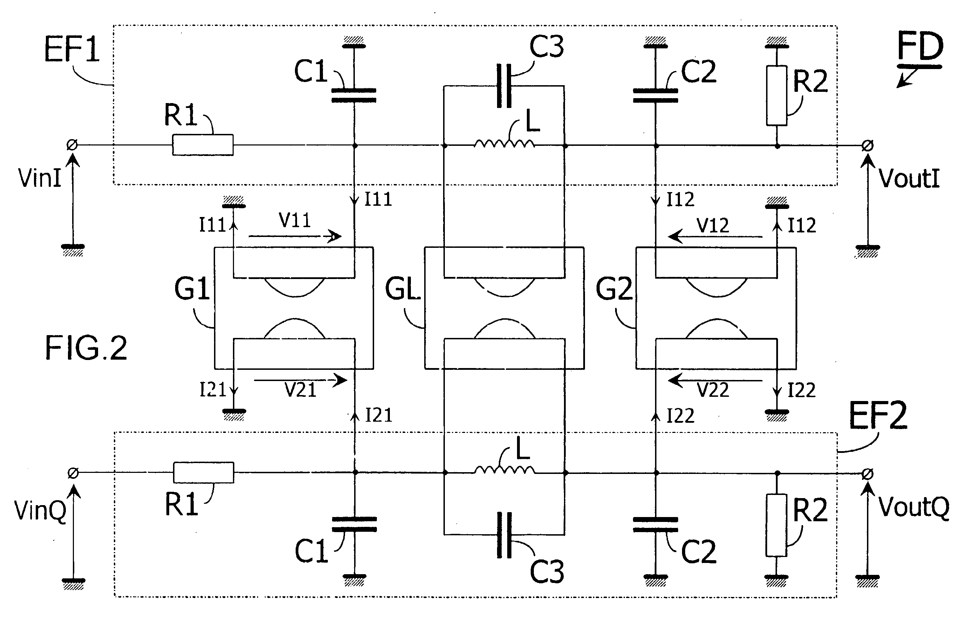

La figure 2 est un schéma électrique qui représente un dispositif de filtrage FD aisément intégrable, dont l'inertie temporelle est plus faible que celle des dispositifs de filtrage connus, et dont l'influence sur la symétrie de la caractéristique de transfert du circuit de réception est réduite. Ce dispositif de filtrage FD est muni d'une première et d'une deuxième entrée, respectivement destinées à recevoir un premier et un deuxième signal d'entrée, VinI et VinQ le deuxième signal d'entrée VinQ étant identique au premier mais en quadrature de phase avec celui-ci, et d'une première et d'une deuxième sortie, respectivement destinées à délivrer un premier et un deuxième signal de sortie VoutI et VoutQ, le deuxième signal de sortie VoutQ étant identique au premier mais en quadrature de phase avec celui-ci. Ce dispositif de filtrage FD comprend un premier filtre elliptique EF1 incluant un filtre passif du troisième ordre, disposé entre la première entrée et la première sortie. Ce filtre passif est constitué d'une première et d'une deuxième résistance R1 et R2, d'une première et d'une deuxième capacité C1 et C2, et d'une inductance L disposée entre les première et deuxième capacités C1 et C2. Dans cet exemple de réalisation, le filtre EF1 est rendu elliptique par une troisième capacité C3 disposée en parallèle avec l'inductance L, créant ainsi un circuit parallèle L - C disposé en série avec le trajet du signal transitant par le filtre EF1. Dans un autre mode de réalisation, on pourra choisir de disposer en parallèle avec le trajet du signal transitant par le filtre EF1 un circuit série L - C. Le filtre elliptique EF1 représenté ici a une caractéristique de transfert présentant au moins un zéro à une fréquence prédéterminée, dite fréquence de coupure. Le dispositif de filtrage FD comprend un deuxième filtre elliptique EF2, identique au premier filtre elliptique EF1, disposé entre la deuxième entrée et la deuxième sortie, et deux gyrateurs G1 et G2, chacun étant connecté en parallèle entre deux éléments capacitifs C1 ou C2 correspondants des premier et deuxième filtre elliptique EF1 et EF2. Les gyrateurs sont configurés de sorte que le dispositif de filtrage FD ait une caractéristique de transfert similaire à celle des premier et deuxième filtre elliptique tout en présentant un décalage dont l'ampleur est égale à la valeur absolue Fc de la fréquence de coupure. Les gyrateurs sont des éléments bien connus de l'homme du métier, et leurs modes de réalisation possibles sont multiples. Chaque gyrateur Gi (pour i=1 ou 2) présente une transconductance gi et est muni d'une première et d'une deuxième entrée, respectivement destinées à recevoir un premier et un deuxième courant I1i et I2i, et d'une première et d'une deuxième sortie, respectivement destinées à délivrer le premier et le deuxième courant I1i et I2i. Le gyrateur Gi est destiné à développer une première tension V1i entre ses premières entrée et sortie, et une deuxième tension V2i entre ses deuxièmes entrée et sorties, le comportement de chaque gyrateur Gi peut être défini par les relations I1i=gi.V2i et I2i=-gi.V1i. Un mode de réalisation particulièrement avantageux d'un tel gyrateur, en ce qu'il permet son intégration sous forme d'un assemblage d'éléments actifs, est décrit dans une publication de l'Ecole Polytechnique de Lausanne ayant pour titre «RF IC Design for Wireless Communication Systems». Selon la figure 2, le dispositif de filtrage FD comprend un autre gyrateur GL, connecté en parallèle avec les troisièmes capacités C3 des premier et deuxième filtres elliptiques EF1 et EF2. Ce gyrateur est complexe et diffère des premier et deuxième gyrateurs G1 et G2, et fait l'objet d'une description séparée.

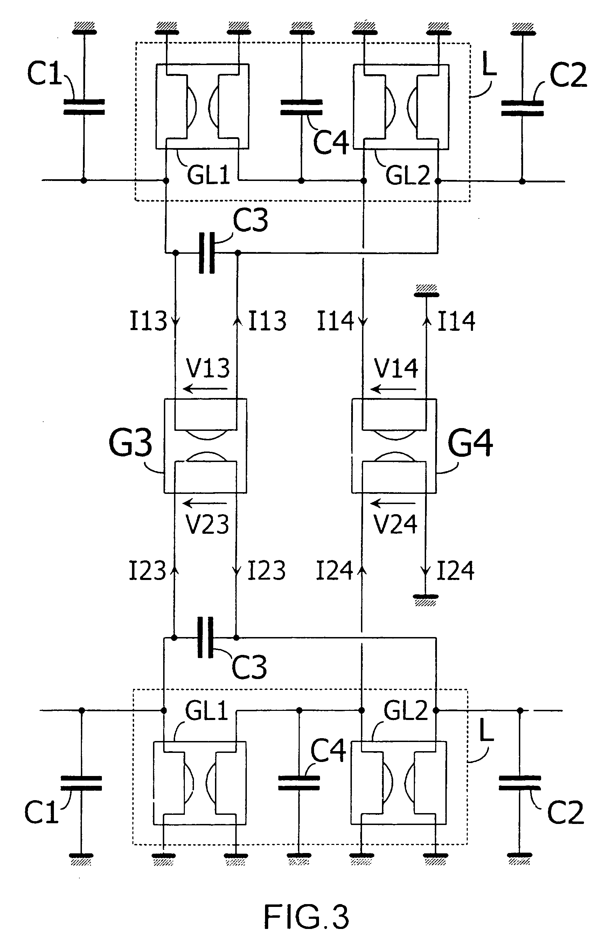

La figure 3 décrit un mode de réalisation de l'inductance L ainsi que le gyrateur complexe GL. Cette présentation séparée a pour but de réduire la densité des figures en vue de faciliter la compréhension des différentes parties composant le dispositif de filtrage FD. Dans un même souci de clarté, les premières et deuxièmes résistances R1 et R2, et les premier et deuxième gyrateurs G1 et G2 ne sont pas représentés sur cette figure. Dans le mode de réalisation décrit ici, chaque inductance L est réalisée sous la forme de deux gyrateurs GL1 et GL2, connectés en parallèle de part et d'autre d'une quatrième capacité C4. Un tel mode de réalisation est connu de l'homme du métier et a pour objet de faciliter la réalisation sous forme intégrée des inductances L des premier et deuxième filtres elliptiques EF1 et EF2. Un troisième gyrateur G3 est connecté en parallèle entre les troisièmes capacités C3 des premier et deuxième filtres elliptiques EF1 et EF2, et un quatrième gyrateur G4 est connecté en parallèle entre les quatrièmes capacités C4 des premier et deuxième filtres elliptiques EF1 et EF2. On trouve ainsi un gyrateur connecté en parallèle entre chaque couple d'éléments capacitifs correspondants des premier et deuxième filtres elliptiques EF1 et EF2.

Les premier, deuxième, troisième et quatrième gyrateurs Gi (pour i=1 à 4) sont configurés de sorte que le dispositif de filtrage FD ait une caractéristique de transfert similaire à celle des premier et deuxième filtres elliptiques EF1 et EF2, tout en présentant un décalage dont l'ampleur est égale à la valeur absolue Fc de la fréquence de coupure. Un mode de réalisation particulier de l'invention, dans lequel on choisit gi=2.Π.Fc.Ci (pour i=1 à 4), permet d'obtenir aisément un tel décalage. Dans un mode de réalisation préféré de l'invention, tous les éléments capacitifs Ci (pour i=1 à 4) inclus dans les premier et deuxième filtres elliptiques EF1 et EF2 auront une même valeur nominale et tous les gyrateurs Gi (pour i=1 à 4) réalisant le décalage en fréquence seront identiques entre eux.

A titre d'exemple, si l'on choisit pour la fréquence de coupure Fc une valeur égale à celle de la fréquence intermédiaire, de l'ordre de la centaine de KiloHertz, les capacités Ci auront, dans le mode de réalisation décrit aux figures 1 et 2 des valeurs nominales de l'ordre du PicoFarad, et la transconductance gi sera de l'ordre du MicroSiemens. De telles capacités sont aisément intégrables, et n'introduisent pas une grande inertie temporelle pour le dispositif de filtrage, dont la constante de temps sera de l'ordre de la microseconde si les résistances qu'il inclut sont de l'ordre de la centaine de KiloOhms.

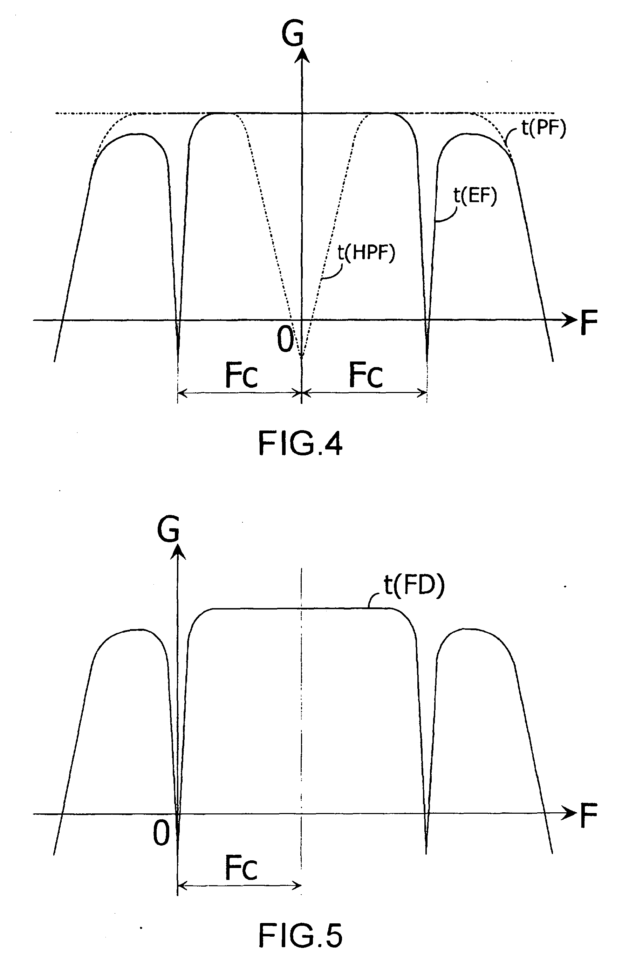

La figure 4 représente une caractéristique de transfert t(EF) décrivant l'évolution du gain en fonction de la fréquence de l'un ou l'autre des filtres elliptiques décrits plus haut. Cette figure décrit en outre, en traits pointillés, l'allure qu'aurait la caractéristique de transfert t(PF) d'un filtre de troisième ordre. La figure décrit de plus, en traits mixtes, l'allure qu'aurait la caractéristique de transfert t(HPF) d'un filtre passe-haut destiné à éliminer une composante continue. A une fréquence Fc, la caractéristique de transfert t(EF) présente un zéro créé par la présence, en série avec le trajet du signal transitant au travers du filtre elliptique, d'un circuit parallèle L - C. Ce zéro se retrouve, par symétrie, dans le domaine des fréquences négatives à la fréquence -Fc. Au-delà de ce zéro, la caractéristique de transfert t(EF) rejoint la caractéristique de transfert t(PF), qui présente l'allure symétrique d'un filtre passe-bande.

La figure 5 représente une caractéristique de transfert t(FD) décrivant l'évolution du gain en fonction de la fréquence dans le dispositif de filtrage conforme à invention. Cette caractéristique t(FD) a une allure similaire à celle du filtre elliptique décrite précédemment, mais a subi un décalage en fréquence de +Fc du fait des gyrateurs, et présente ainsi un zéro à la fréquence nulle. Ceci assure l'élimination par le dispositif de filtrage conforme à l'invention de la composante continue du signal qui le traverse. Si, dans cet exemple, on a choisi d'opérer un décalage dans le sens des fréquences croissantes, un décalage dans le sens opposé est tout aussi aisément réalisable et assurera également le filtrage de ladite composante continue. La symétrie de la caractéristique de transfert t(FD) par rapport à la fréquence de coupure Fc, qui sera avantageusement choisie à la fréquence intermédiaire, est donc préservée dans une large mesure, ce qui n'est pas le cas pour le filtre passe-haut, dont la caractéristique de transfert t(HPF) est symétrique autour de la fréquence nulle.

## Revendications

1. Dispositif de filtrage pour éliminer une composante continue d'un signal électronique, comprenant:
- un filtre ayant une caractéristique de transfert présentant au moins un zéro à une fréquence prédéterminée afin qu'il y ait un minimum de gain à cette fréquence,
- une pluralité de gyrateurs couplée au filtre et agencée pour opérer un décalage en fréquence de ladite caractéristique de transfert, le décalage en fréquence ayant une ampleur égale à la valeur absolue de ladite fréquence prédéterminée afin que le minimum de gain du dispositif de filtrage se présente sensiblement à la fréquence nulle.

2. Dispositif de filtrage selon la revendication 1 muni d'une première et d'une deuxième entrée, respectivement destinées à recevoir un premier et un deuxième signal d'entrée, le deuxième signal d'entrée étant identique au premier mais en quadrature de phase avec celui-ci, et d'une première et d'une deuxième sortie, respectivement destinées à délivrer un premier et un deuxième signal de sortie, le deuxième signal de sortie étant identique au premier mais en quadrature de phase avec celui-ci, dispositif **caractérisé en ce qu'**il comporte:
- un premier filtre elliptique incluant N éléments capacitifs Ci (pour i=1 à N), disposé entre la première entrée et la première sortie, filtre ayant une caractéristique de transfert présentant au moins un zéro à une fréquence prédéterminée,
- un deuxième filtre elliptique, identique au premier filtre elliptique, disposé entre la deuxième entrée et la deuxième sortie, et
- N gyrateurs Gi (pour i =1 à N), chacun étant connecté en parallèle entre deux éléments capacitifs Ci (pour i=1 à N) correspondants des premier et deuxième filtres elliptiques, les gyrateurs étant configurés de sorte que le dispositif de filtrage ait une caractéristique de transfert similaire à celle des premier et deuxième filtres elliptiques tout en présentant un décalage dont l'ampleur est égale à la valeur absolue de la fréquence prédéterminée à laquelle lesdits filtres elliptiques présentent au moins un zéro.

3. Dispositif de filtrage confirme à la revendication 2, **caractérisé en ce que,** chaque gyrateur Gi (pour i=1 à N) présente une transconductance gi et est muni d'une première et d'une deuxième entrée, respectivement destinées à recevoir un premier et un deuxième courant I1i et I2i, et d'une première et d'une deuxième sortie, respectivement destinées à délivrer le premier et le deuxième courant I1i et I2i, ledit gyrateur étant destiné à développer une première tension V1i entre ses premières entrée et sortie, et une deuxième tension V2i entre ses deuxièmes entrée et sorties, le comportement de chaque gyrateur est défini par les relations :
I1i=gi.V2i et I2i=-gi.V1i, et
gi=2. II .Fc.Ci, où Fc est la valeur absolue de la fréquence prédéterminée à la laquelle lesdits filtres elliptiques présentent au moins un zéro.

4. Dispositif de filtrage conforme à la revendication 3, **caractérisé en ce que** tous les éléments capacitifs Ci (pour i=1 à N) inclus dans les premier et deuxième filtres elliptiques ont une même valeur nominale, et **en ce que** tous les gyrateurs Gi (pour i=1 à N) sont identiques entre eux.

5. Appareil de radiotéléphonie, comportant:
- un système d'antenne et de filtrage destiné à assurer la réception d'un signal radioélectrique et à délivrer sur une sortie un signal électronique représentatif dudit signal,
- un amplificateur relié à la sortie du système d'antenne et de filtrage et destiné à délivrer sur une sortie un signal électronique amplifié,
- un mélangeur muni d'une première entrée reliée à la sortie de l'amplificateur, d'une deuxième entrée destinée à recevoir un signal en provenance d'un oscillateur local, et d'une sortie destinée à délivrer un signal ayant une fréquence fixe appelée fréquence intermédiaire, et
- un démodulateur muni d'une entrée reliée à la sortie du mélangeur et d'une sortie destinée à délivrer un signal audio démodulé,
appareil **caractérisé en ce qu'**il comporte en outre un dispositif de filtrage conforme à la revendication 2, inséré entre le mélangeur et le démodulateur, la fréquence prédéterminée à la laquelle lesdits filtres elliptiques présentent au moins un zéro correspondant à la fréquence intermédiaire.

## Claims

1. A filter device for eliminating a DC component of an electronic signal, comprising:
- a filter having a transfer characteristic featuring at least a zero at a predetermined frequency, so that it has minimum gain at this frequency,
- a plurality of gyrators coupled to the filter and arranged for causing a frequency shift of said transfer characteristic, the frequency shift having an extent equal to the absolute value of said predetermined frequency, so that the minimum gain of the filter device perceptibly presents itself at the zero frequency.

2. A filter device as claimed in claim 1, having a first and a second input intended to receive a first and a second input signal respectively, the second input signal being identical to the first but in phase quadrature to the first, and having a first and a second output intended to deliver a first and a second output signal respectively, the second output signal being identical to the first but in phase quadrature to the first, which device is **characterized in that** it comprises:
- a first elliptical filter including N capacitive elements Ci (for i = 1 to N), arranged between the first input and the first output, the filter having a transfer characteristic that features at least a zero at a predetermined frequency,
- a second elliptical filter, identical to the first elliptical filter, arranged between the second input and the second output, and
- N gyrators Gi (for i = 1 to N), each being connected in parallel between two corresponding capacitive elements Ci (for i = 1 to N) of the first and second elliptical filters, the gyrators being designed such that the filter device has a similar transfer characteristic to that of the first and second elliptical filters while featuring a shift whose extent is equal to the absolute value of the predetermined frequency at which said elliptical filters feature at least a zero.

3. A filter device as claimed in claim 2, **characterized in that,** while each gyrator Gi (for i = 1 to N) has a transconductance gi and has a first and a second input intended to receive a first and a second current I1i and I2i respectively, and a first and a second output intended to deliver the first and the second current I1i and I2i respectively, said gyrator is intended to develop a first voltage V1i between its first input and output, and a second voltage V2i between its second input and output, the behavior of each gyrator is defined by the relationships:
I1i = gi.V2i and 12i = -gi.V1i, and
gi = 2.Π.Fc.Ci, where Fc is the absolute value of the predetermined frequency at which said elliptical filters feature at least a zero.

4. A filter device as claimed in claim 3, **characterized in that** all the capacitive elements Ci (for i = 1 to N) included in the first and second elliptical filters have an identical nominal value, and **in that** all the gyrators Gi (for i = 1 to N) are mutually identical.

5. A radiotelephony device, comprising
- an antenna and filter system intended to ensure the reception of a radio signal and to deliver on an output an electronic signal representing said signal,
- an amplifier connected to the output of the antenna and filter system and intended to deliver an amplified electronic signal on an output,
- a mixer having a first input connected to the output of the amplifier, a second input intended to receive a signal that comes from a local oscillator, and an output intended to deliver a signal that has a fixed frequency called intermediate frequency, and
- a demodulator having an input connected to the output of the mixer and an output intended to deliver a demodulated audio signal,
which device is **characterized in that** it further includes a filter device as described in claim 2, inserted between the mixer and the demodulator, the predetermined frequency at which said elliptical filters feature at least a zero corresponding to the intermediate frequency.

## Patentansprüche

1. Filtervorrichtung zur Entfernung einer kontinuierlichen Komponente eines elektronischen Signals, die folgendes umfasst:
- einen Filter mit einem Übertragungsmerkmal, der zumindest eine Null bei einer vorbestimmten Frequenz aufweist, um bei dieser Frequenz einen Mindestgewinn zu erzielen,
- eine Vielzahl von Gyratoren, die mit dem Filter gekoppelt und angeordnet sind, um eine Frequenzverschiebung dieses Übertragungsmerkmals zu bewirken, wobei die Frequenzverschiebung eine Breit gleich dem absoluten Wert der genannten vorbestimmten Frequenz hat, damit sich der Mindestgewinn der Filtervorrichtung spürbar bei der Nullfrequenz darstellt.

2. Filtervorrichtung nach Anspruch 1, die mit einer ersten und einer zweiten Eingabe zur Aufnahme eines ersten und eines zweiten Eingabesignals, wobei das zweite Eingabesignal dem ersten aber in Phasenquadratur mit demselbigen gleicht, und mit einer ersten und einer zweiten Ausgabe jeweils zur Lieferung eines ersten und eines zweiten Ausgabesignals, wobei das zweite Ausgabesignal dem ersten aber in Phasenquadratur desselbigen gleicht, versehen ist, **dadurch gekennzeichnet, das** es folgendes umfasst:
- einen ersten elliptischen Filter, der N kapazitive Elemente Ci einschließt (für i = 1 bei N), der zwischen der ersten Eingabe und der ersten Ausgabe angeordnet wird und ein Übertragungsmerkmal aufweist, das bei einer vorbestimmten Frequenz zumindest eine Null darstellt.
- einen zweiten elliptischen Filter, der dem ersten elliptischen Filter gleicht und zwischen der zweiten Eingabe und der zweiten Ausgabe angeordnet ist, und
- N Gyratoren Gi (für i = 1 bei N), die jeweils parallel zwischen zwei entsprechenden kapazitiven Elementen Ci (für i = 1 bei Null) des ersten und zweiten elliptischen Filters derart angeschlossen sind, dass die Filtervorrichtung ein Übertragungsmerkmal aufweist, das dem des ersten und des zweiten elliptischen Filters gleicht, wobei sie eine Verschiebung aufweisen, deren Breite dem absoluten Wert der vorbestimmten Frequenz entspricht, bei der diese elliptischen Filter zumindest eine Null aufweisen.

3. Filtervorrichtung nach Anspruch 2, **dadurch gekennzeichnet, dass** jeder Gyrator (Gi (für i = 1 bei N) einen Gegenwirkleitwert gi aufweist und mit einer ersten und einer zweiten Eingabe versehen ist, die jeweils zur Lieferung eines ersten und eines zweiten Stroms I1i und I2i bestimmt ist, wobei dieser Gyrator für die Entwicklung einer ersten Spannung V1i zwischen seiner ersten Ein- und Ausgabe und einer zweiten Spannung V2i zwischen seiner zweiten Ein- und Ausgabe n vorgesehen ist und das Verhalten jedes Gyrators durch das nachstehende Verhältnis bestimmt ist:
I1i = gi.V2i und I2i = gi.V1i und
Gi = 2.Π.Fc.Ci, wobei Fc der absolute Wert der vorbestimmten Frequenz ist, bei der die genannten elliptischen Filter zumindest eine Null aufweisen.

4. Filtervorrichtung nach Anspruch 3, **dadurch gekennzeichnet, dass** alle kapazitiven Elemente Ci (für i = 1 bei N), die im ersten und zweiten elliptischen Filter inbegriffen sind, ein und denselben Nennwert aufweisen und dass alle Gyratoren Gi (für I = 1 bei N) untereinander identisch sind.

5. Funkgeräte, das folgendes umfasst:
- ein Antennen- und Filtersystem zur Gewährleistung des Empfangs eines Funksignals und zur Lieferung eines elektronischen Signals, das für dieses Signal repräsentativ ist, an einer Ausgabe,
- einen Verstärker, der mit der Ausgabe des Antennen- und Filtersystems verbunden und zur Lieferung eines verstärkten elektronischen Signals an einer Ausgabe bestimmt ist,
- einen Mischer, der mit einer ersten Eingabe, die an der Ausgabe des Verstärkers mit einer zweiten Eingabe verbunden ist, welche zur Aufnahme eines Signals bestimmt ist, das von einem lokalen Schwinger stammt, sowie mit einer Ausgabe zur Lieferung eines Signals mit einer Festfrequenz, die Zwischenfrequenz genannt wird, versehen ist, und
- einen Demodulator, der mit einer Eingabe versehen ist, die mit der Ausgabe des Mischers und einer Ausgabe verbunden ist, die zur Lieferung eines demodulierten Audiosignals bestimmt ist,
Gerät, **dadurch gekennzeichnet, dass** es ferner eine Filtervorrichtung nach Anspruch 2 umfasst, die zwischen dem Mischer und dem Demodulator eingefügt wird, wobei die vorbestimmte Frequenz, bei der die genannten elliptischen Filter zumindest eine Null aufweisen, der Zwischenfrequenz entspricht.
